# FASCICULE DE BREVET EUROPEEN

(11) **EP 1 362 417 B1**
(45) Date de publication et mention de la délivrance du brevet: **04.04.2007**
(21) Numéro de dépôt: 01270952.3
(22) Date de dépôt: 14.12.2001
(51) Int. Cl.: H03G 1/00

(54) **AMPLIFICATEUR A ENTREE ET SORTIE DIFFERENTIELLES A GAIN VARIABLE**
VERSTÄRKER MIT SYMMETRISCHEN EIN- UND AUSGÄNGEN UND MIT VARIABLER VERSTÄRKUNG
VARIABLE-GAIN DIFFERENTIAL INPUT AND OUTPUT AMPLIFIER

(30) Priorité: 15.12.2000 FR 0016400
(43) Date de publication de la demande: 19.11.2003
(73) Titulaire: STMicroelectronics S.A., 92120 Montrouge (FR)
(72) Inventeur: MOURET, Michel, F-38560 Jarrie (FR); SABUT, Marc, F-38320 Eybens (FR); VAN ZANTEN, François, F-38240 Meylan (FR)
(74) Mandataire: de Beaumont, Michel
(86) Numéro de dépôt international: PCT/FR2001/004007
(87) Numéro de publication internationale: WO 2002/049210

(56) Documents cités:
- WO-A-00/72446
- US-A- 5 684 431
- US-A- 5 880 618
- US-A- 5 917 380

## Description

La présente invention concerne un amplificateur à gain variable, et en particulier un tel amplificateur à entrée et sortie différentielles et dont le gain varie de manière exponentielle en réponse à une tension de commande analogique.

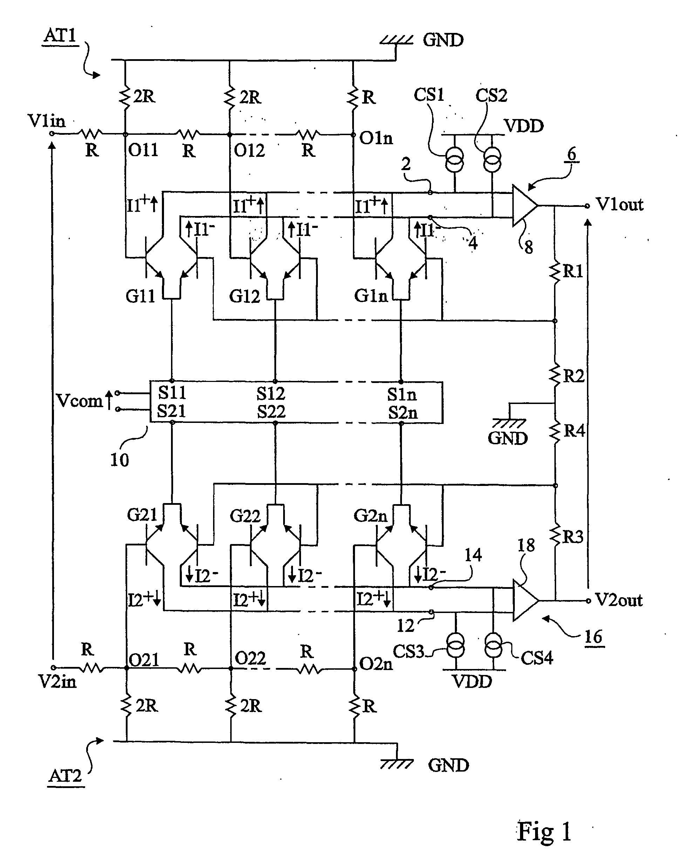

La figure 1 représente schématiquement un amplificateur, réalisable sous forme de circuit intégré, dont le gain varie exponentiellement en réponse à une tension de commande analogique Vcom. L'amplificateur est destiné à recevoir une tension différentielle V1in-V2in et à fournir en réponse une tension différentielle V1out-V2out.

Le potentiel V1in est fourni à un réseau atténuateur AT1 référencé à un potentiel de masse GND et ayant n noeuds de sortie O1i (i étant compris entre 1 et n). Chaque noeud de sortie O1i produit un potentiel de commande égal au potentiel d'entrée V1in atténué selon un rapport prédéterminé, par exemple 2ⁱ dans le cas où le réseau AT1 est un réseau R/2R. L'amplificateur comprend un premier ensemble d'éléments transconducteurs G1i commandables en courant et constitués par exemple de deux transistors bipolaires connectés de la façon représentée. Chaque élément transconducteur G1i reçoit sur une première entrée le potentiel produit par le noeud O1i de même rang i. Chaque élément transconducteur G1i est prévu pour fournir un courant positif I1⁺ sur une borne de sortie en courant 2 et un courant négatif I1⁻ sur une borne de sortie en courant 4. Les bornes de sortie 2 et 4 constituent respectivement les première et seconde bornes d'entrée d'un bloc de sortie 6. Le bloc de sortie 6 comprend un élément de conversion courant/tension 8 ayant deux bornes d'entrée et une borne de sortie. Les deux bornes d'entrée du convertisseur 8 correspondent aux deux bornes d'entrée du bloc 6. Deux sources de courant CS1, CS2 sont disposées entre un potentiel d'alimentation VDD et respectivement les première et seconde bornes d'entrée du bloc 6. La borne de sortie du convertisseur 8 est reliée au potentiel GND par l'intermédiaire d'un pont diviseur formé de deux résistances R1, R2, dont le point milieu est connecté de manière à fournir un signal de contre-réaction à une deuxième entrée de chaque élément transconducteur G1i. La borne de sortie du convertisseur 8 fournit un potentiel V1out. L'amplificateur comporte en outre un ensemble de sources de courant commandables 10 ayant n bornes de sortie S1i. Chaque borne de sortie S1i est connectée de manière à commander la transconductance de l'élément transconducteur G1i de même rang i. L'ensemble de sources de courant 10 est commandé par une tension analogique de commande Vcom.

Le potentiel V2in est fourni à un réseau atténuateur AT2 identique au réseau AT1, référencé au potentiel GND, et ayant n noeuds de sortie O2i. L'amplificateur comprend un second ensemble d'éléments transconducteurs G2i commandables en courant, dont chacun reçoit sur une première entrée le potentiel produit par le noeud O2i de même rang i. Chaque élément transconducteur G2i est prévu pour fournir un courant positif I2⁺ sur une borne de sortie en courant 12 et un courant négatif I2⁻ sur une borne de sortie en courant 14, constituant respectivement les première et seconde bornes d'entrée d'un bloc de sortie 16. Le bloc de sortie 16 comprend un élément de conversion courant/tension 18 dont les deux bornes d'entrée sont reliées aux deux bornes d'entrée du bloc 16. Deux sources de courant CS3, CS4 sont respectivement disposées entre le potentiel d'alimentation VDD et les première et seconde bornes d'entrée du bloc 16. La sortie du convertisseur 18 est reliée au potentiel GND par l'intermédiaire d'un pont diviseur formé de deux résistances R3, R4, dont le point milieu est connecté de manière à fournir un signal de contre-réaction à une deuxième entrée de chaque élément transconducteur G2i. La borne de sortie du convertisseur 18 fournit un potentiel V2out. L'ensemble de sources de courant 10 comporte n bornes de sortie S2i dont chacune est reliée à un élément transconducteur de même rang i.

Les réseaux atténuateurs AT1 et AT2 forment un bloc atténuateur différentiel recevant le signal différentiel d'entrée V1in - V2in. Chaque couple de noeuds de sortie O1i, O2i du bloc atténuateur différentiel fournit une tension de commande au couple d'éléments transconducteurs G1i, G2i de même rang. Chaque couple d'éléments transconducteurs G1i, G2i forme un élément transconducteur différentiel. Les blocs de sortie 6 et 16 forment un bloc de sortie différentiel recevant les courants fournis par chaque élément transconducteur différentiel G1i, G2i et produisant le signal de sortie différentiel V1out-V2out. Les couples de sorties S1i, S2i de l'ensemble de sources de courant 10 produisent des couples de courant de commande appariés pour commander chaque élément transconducteur différentiel G1i, G2i. L'amplificateur décrit ci-dessus fait l'objet d'une demande de brevet français non encore publiée et ne fait pas partie de l'état de la technique.

Pour qu'un tel amplificateur ait un fonctionnement satisfaisant, il faut que les éléments de conversion courant/tension 8 et 18 soient appariés. Dans le cas contraire, la moitié de l'amplificateur qui reçoit le potentiel V1in et produit le potentiel V1out et la moitié de l'amplificateur qui reçoit le potentiel V2in et produit..le potentiel V2out ont des gains et des bandes passantes différents, ce qui entraîne une distorsion du signal de sortie de l'amplificateur. En pratique, il est délicat de réaliser deux convertisseurs courant/tension 8 et 18 appariés.

En outre, les couples de sources de courant CS1, CS2, et CS3, CS4 fonctionnent de manière décorrélée, ce qui peut contribuer à augmenter le niveau de bruit de l'amplificateur.

En outre, chacun des signaux de tension V1out et V2out est produit par un amplificateur non symétrique qui n'élimine pas la distorsion liée à l'harmonique d'ordre deux.

Un objet de la présente invention est de prévoir un amplificateur à entrée et sortie différentielles à gain variable, dont le gain varie de manière exponentielle en réponse à une tension de commande analogique, qui présente une faible distorsion harmonique et à faible bruit.

Pour atteindre cet objet, ainsi que d'autres, la présente invention prévoit notamment un amplificateur à entrée et sortie différentielles à gain variable comprenant un bloc atténuateur référencé au potentiel de mode commun de la sortie de l'amplificateur, recevant une tension d'entrée et propre à fournir sur plusieurs sorties des tensions dont chacune est égale à la tension d'entrée atténuée selon un rapport prédéterminé ; des éléments transconducteurs différentiels commandables en courant, chaque élément transconducteur différentiel ayant une première entrée reliée à une sortie du bloc atténuateur, chaque élément transconducteur différentiel produisant des premier et second courants positifs et des premier et second courants négatifs ; un ensemble de sources de courant propre à commander la transconductance de chaque élément transconducteur différentiel en fonction d'un signal de commande analogique ; et un bloc de sortie convertissant des premier et second courants d'entrée en une tension de sortie différentielle et fournissant à une seconde entrée de chaque élément transconducteur différentiel une tension de contre-réaction dépendant de la tension de sortie, le premier courant d'entrée étant égal à la somme des premiers courants positifs et des seconds courants négatifs et le second courant d'entrée étant égal à la somme des seconds courants positifs et des premiers courants négatifs.

Selon un mode de réalisation de la présente invention, le bloc atténuateur comprend deux réseaux atténuateurs de type R/2R recevant respectivement des premier et second potentiels d'entrée, chaque sortie du bloc atténuateur comprenant un noeud de sortie de chaque réseau atténuateur, le noeud de sortie produisant un potentiel atténué égal au potentiel d'entrée reçu par ledit réseau, atténué selon le rapport prédéterminé propre à ladite sortie; chaque élément transconducteur différentiel comprend deux couples de transistors bipolaires, les émetteurs des transistors d'un premier couple étant reliés à une première borne de commande en courant de l'élément transconducteur différentiel, et les émetteurs des transistors du second couple étant reliés à une seconde borne de commande en courant de l'élément transconducteur différentiel, la première entrée de l'élément transconducteur différentiel étant constituée par les bases de deux premiers transistors des deux couples de transistors, la seconde entrée de l'élément transconducteur différentiel étant constituée par les bases des deux seconds transistors des deux couples de transistors, les deux bases constituant la première entrée de l'élément transconducteur différentiel étant respectivement reliées aux deux noeuds de sortie de la sortie du bloc atténuateur reliée à l'élément transconducteur différentiel, les deux bases constituant la seconde entrée de l'élément transconducteur différentiel étant soumises à la tension de contre-réaction, les collecteurs des premiers transistors produisant les premier et second courants positifs, et les collecteurs des seconds transistors produisant les premier et second courants négatifs ; et l'ensemble de sources de courant comporte des couples de bornes de commande reliés aux première et seconde bornes de commande en courant de chaque élément transconducteur différentiel.

Selon un mode de réalisation de la présente invention, le bloc de sortie comporte : un élément de conversion courant/tension ayant des première et seconde bornes d'entrée respectivement prévues pour recevoir les premier et second courants d'entrée, produisant le potentiel de mode commun sur une borne de sortie de mode commun, et produisant respectivement des premier et second potentiels de sortie sur des première et seconde bornes de sortie ; des premier et second ponts diviseurs résistifs respectivement disposés entre les première et seconde bornes de sortie de l'élément de conversion courant/tension et le potentiel de mode commun, le point milieu des premier et second ponts diviseurs résistifs produisant la tension de contre-réaction ; et des première et seconde sources de courant respectivement disposées entre un potentiel d'alimentation et les première et seconde bornes d'entrée du bloc de sortie.

Selon un mode de réalisation de la présente invention, l'élément de conversion courant/tension comprend: des premier et deuxième transistors MOS identiques de type P, dont les sources sont reliées au potentiel d'alimentation, dont les grilles sont reliées l'une à l'autre, dont les drains respectifs sont reliés aux première et seconde bornes d'entrée de l'élément de conversion courant/tension ; des troisième et quatrième transistors MOS identiques, de type P, dont les sources sont reliées au potentiel d'alimentation, dont les grilles respectives sont reliées aux drains respectifs des premier et deuxième transistors MOS, dont les drains respectifs sont reliés aux première et seconde bornes de sortie de l'élément de conversion courant/tension ; des troisième et quatrième sources de courant disposées entre les drains respectifs des troisième et quatrième transistors et un premier potentiel de référence ; deux résistances identiques reliées chacune entre les drains respectifs des troisième et quatrième transistors et la borne de sortie de mode commun ; et un amplificateur différentiel dont une première entrée est reliée à la borne de sortie de mode commun, dont une seconde entrée est reliée à un second potentiel de référence, et dont la sortie est reliée aux grilles des premier et second transistors.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1, précédemment décrite, représente schématiquement un amplificateur à gain variable classique ;
la figure 2 représente schématiquement un amplificateur à gain variable selon la présente invention;
la figure 3 représente schématiquement un mode de réalisation de l'élément de conversion courant/tension de la figure 2 ; et
la figure 4 représente schématiquement un mode de réalisation de l'ensemble de sources de courant commandables de la figure 2.

Dans les figures qui suivent, seuls les éléments nécessaires à la compréhension de la présente invention ont été représentés. De mêmes références représentent de mêmes éléments à la figure précédente et aux figures suivantes.

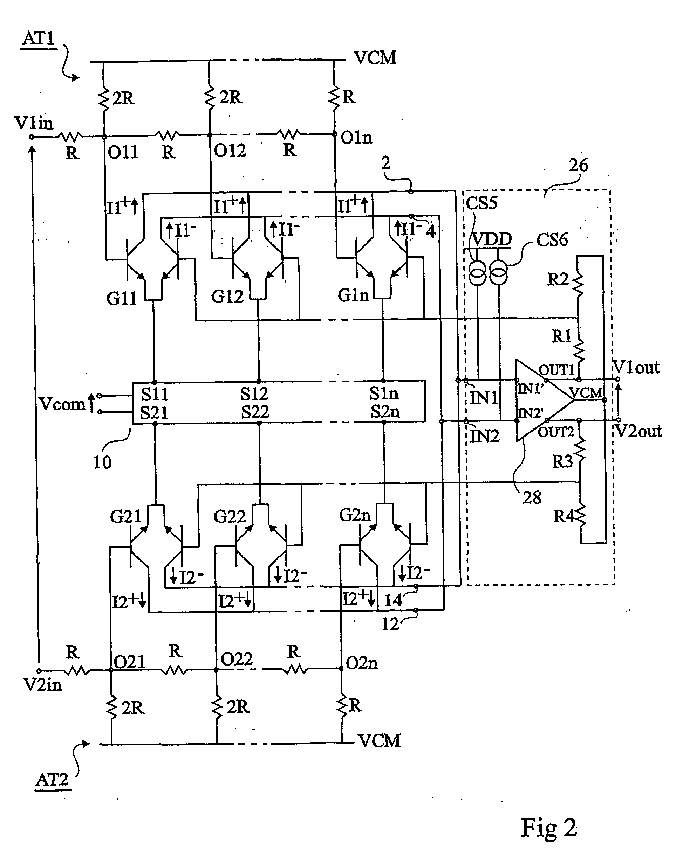

La figure 2 représente schématiquement un amplificateur à gain variable selon la présente invention, destiné à recevoir une tension différentielle V1in-V2in et à fournir en réponse une tension différentielle V1out-V2out. L'amplificateur comprend un premier réseau atténuateur AT1 de type R/2R recevant le potentiel V1in sur une borne d'entrée et ayant n noeuds de sortie O1i. Selon la présente invention, le réseau atténuateur AT1 est référencé au potentiel de mode commun VCM de la sortie de l'amplificateur. L'amplificateur comprend un premier ensemble d'éléments transconducteurs G1i commandables en courant, dont chacun reçoit sur une première entrée le potentiel produit par le noeud O1i de même rang i. Chaque élément transconducteur G1i comprend un couple de transistors bipolaires dont les émetteurs sont reliés à une borne de commande en courant de l'élément G1i. La base d'un premier transistor constitue une première entrée de l'élément G1i. La base du second transistor constitue une seconde entrée de l'élément G1i. Le collecteur du premier transistor fournit un courant positif I1⁺ à une borne de sortie en courant 2. Le collecteur du second transistor fournit un courant négatif I1⁻ à une borne de sortie en courant 4. L'amplificateur comprend un second réseau atténuateur AT2 identique au réseau AT1, recevant le potentiel V2in sur une borne d'entrée, ayant n noeuds de sortie O2i, et référencé au potentiel VCM. L'amplificateur comprend un second ensemble d'éléments transconducteurs G2i commandables en courant, dont chacun reçoit sur une première entrée le potentiel produit par le noeud O2i de même rang i. Chaque élément transconducteur G2i comprend un couple de transistors bipolaires dont les émetteurs sont reliés à une borne de commande en courant de l'élément G2i. La base d'un premier transistor constitue une première entrée de l'élément G2i. La base du second transistor constitue une seconde entrée de l'élément G2i. Le collecteur du premier transistor fournit un courant positif I2⁺ à une borne de sortie en courant 12. Le collecteur du second transistor fournit un courant négatif I2⁻ à une borne de sortie en courant 14.

Les éléments transconducteurs G1i et G2i de même rang forment un élément transconducteur différentiel G1i, G2i. La transconductance de chaque élément transconducteur différentiel G1i, G2i est commandée par des couples de sorties S1i, S2i d'un ensemble 10 de sources de courant commandables reliées aux bornes de commande en courant de l'élément transconducteur différentiel. Un exemple de réalisation de l'ensemble 10 de sources de courant est décrit par la suite.

Selon la présente invention, l'amplificateur comprend un unique bloc de sortie 26 ayant des première et seconde bornes d'entrée IN1, IN2 et comportant un élément de conversion courant/tension 28. L'élément de conversion courant/tension 28 a des première et seconde bornes d'entrée IN1' et IN2' respectivement reliées aux bornes IN1 et IN2. L'élément de conversion courant/tension 28 comporte en outre des première et seconde bornes de sortie OUT1, OUT2 et une borne de sortie de mode commun produisant le potentiel VCM. La borne IN1 est reliée aux bornes de sortie en courant 2 et 14. La borne IN1 reçoit un premier courant d'entrée égal à la somme des courants positifs I1⁺ produits par les éléments transconducteurs G1i et des courants négatifs I2⁻ produits par les éléments transconducteurs G2i. La borne IN2 est reliée aux bornes de sortie en courant 4 et 12. La borne IN2 reçoit un second courant d'entrée égal à la somme des courants négatifs I1⁻ produits par les éléments transconducteurs G1i et des courants positifs I2⁺ produits par les éléments transconducteurs G2i. Une source de courant CS5 est disposée entre la borne IN1 et un potentiel d'alimentation VDD. Une source de courant CS6 est disposée entre la borne IN2 et le potentiel d'alimentation VDD. La première borne de sortie OUT1 de l'élément 28 est reliée au potentiel VCM par l'intermédiaire d'un premier pont diviseur formé de deux résistances R1, R2. Le point milieu du premier pont diviseur est connecté de manière à fournir un signal de contre-réaction à la deuxième borne d'entrée de chaque élément transconducteur G1i. La seconde borne de sortie OUT2 de l'élément 28 est reliée au potentiel VCM par l'intermédiaire d'un second pont diviseur formé de deux résistances R3, R4. Le point milieu du second pont diviseur est connecté de manière à fournir un signal de contre-réaction à la deuxième borne d'entrée de chaque élément transconducteur G2i. La borne de sortie OUT1 fournit le potentiel de sortie V1out et la borne de sortie OUT2 fournit le potentiel de sortie V2out.

L'amplificateur selon la présente invention produit le signal différentiel de tension V1out-V2out à partir du signal différentiel de tension V1in-V2in au moyen d'un unique élément de conversion courant/tension 28, ce qui permet de supprimer les problèmes de distorsion liés aux difficultés d'appariement des deux éléments de conversion courant/tension d'un amplificateur classique.

Les première et seconde bornes d'entrée IN1 et IN2 de l'élément de conversion courant/tension 28 sont chacune reliée à une seule source de courant, respectivement CS5 et CS6. Les deux sources de courant CS5 et CS6 remplacent les deux couples de sources de courant CS1, CS2 et CS3, CS4 fonctionnant de manière décorrélée d'un amplificateur classique, ce qui permet de réduire le bruit provenant de l'alimentation VDD.

L'amplificateur selon la présente invention est un montage symétrique qui élimine le terme d'harmonique second du signal de sortie V1out-V2out.

L'entrée de l'amplificateur selon la présente invention est un signal différentiel référencé au potentiel de mode commun VCM. Il en résulte que, pour une dynamique donnée, on peut utiliser un potentiel d'alimentation plus faible que dans le cas de deux bornes d'entrée référencées à la masse.

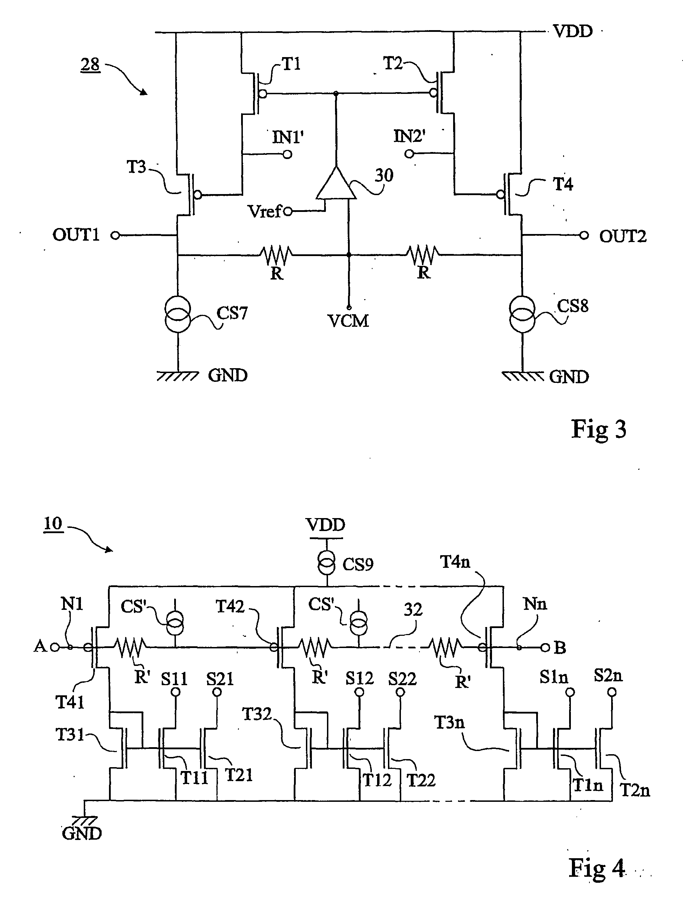

La figure 3 représente schématiquement un mode de réalisation de l'élément de conversion courant/tension 28. Deux transistors MOS identiques T1 et T2, de type P, ont leur sources reliées au potentiel VDD et leurs grilles reliées l'une à l'autre. Les drains respectifs des transistors T1 et T2 sont reliés aux bornes IN1' et IN2'. Deux transistors MOS identiques T3 et T4, de type P, ont leur sources reliées au potentiel VDD et leurs grilles respectives reliées aux bornes IN1' et IN2'. Les drains respectifs des transistors T3 et T4 sont reliés aux bornes OUT1 et OUT2. Des sources de courant CS7 et CS8 sont respectivement disposées entre les drains respectifs des transistors T3 et T4 et un potentiel de masse GND. Le drain de chacun des transistors T3 et T4 est relié à la borne de sortie de mode commun par une résistance R. Un amplificateur différentiel 30 a une première entrée reliée à la borne de sortie de mode commun et une seconde entrée reliée à un potentiel de référence Vref. La sortie de l'amplificateur 30 est reliée aux grilles des transistors T1 et T2.

La figure 4 représente schématiquement un mode de réalisation de l'ensemble de sources de courant commandables 10. L'ensemble de sources de courant 10 comporte n couples de bornes de sortie S1i, S2i et deux bornes de commande A et B. La tension de commande Vcom est fournie entre les bornes A et B. Chaque borne de sortie S1i, S2i est respectivement reliée au drain de transistors MOS T1i, T2i, à canal N. Les transistors T1i et T2i sont appariés. La source des transistors T1i, T2i est reliée à la masse (GND). Le couple de transistors T1i, T2i est associé à un transistor MOS T3i, à canal N, et à un transistor MOS T4i, à canal P. La source du transistor T3i est reliée à la masse. La grille et le drain du transistor T3i sont reliés l'un à l'autre. La grille des transistors T1i, T2i est reliée à la grille du transistor T3i de manière que deux courants appariés dépendant du courant dans le transistor T3i traversent les transistors T1i et T2i. Le drain du transistor T3i est relié au drain du transistor T4i, de manière que ces transistors sont en série. La source du transistor T4i est reliée au potentiel d'alimentation VDD par l'intermédiaire d'une unique source de courant constant CS9. La grille du transistor T4i est reliée à un noeud Ni d'un moyen de commande 32 constitué de résistances R' et de sources de courant CS'. Dans le moyen de commande 32, le premier noeud N1 est couplé à la borne A, le dernier noeud Nn est couplé à la borne B, chaque noeud Nj (j étant compris entre 1 et n-1) est relié au noeud Nj+1 par l'intermédiaire d'une résistance R' et chaque noeud Nj (j étant compris entre 2 et n-1) est relié à une première borne d'une source de courant constant CS' propre à ce noeud. Le moyen de commande 32 est prévu pour rendre successivement chaque transistor T4i progressivement conducteur puis progressivement non conducteur lorsque la tension Vcom subit une variation prédéterminée, de manière que la somme des courants traversant les transistors T4i est sensiblement constante. Chaque borne de sortie S1i, S2i fournit un courant dépendant du courant traversant le transistor T4i.

Bien entendu, la présente invention est susceptible de diverses variantes et modifications qui apparaîtront à l'homme de l'art. La présente invention a été décrite en relation avec un ensemble de sources de courant commandables 10 particulier, mais l'homme du métier adaptera sans difficultés la présente invention à un ensemble de sources de courant ayant une fonction équivalente. Par exemple, un tel ensemble peut être obtenu par un doublement de l'ensemble de sources de courant utilisé pour commander l'amplificateur à gain variable à entrée et sortie non différentielles décrit dans le brevet US-A-5077541.

La présente invention a été décrite en relation avec un bloc atténuateur différentiel utilisant des réseaux diviseurs R/2R, mais l'homme du métier adaptera sans difficultés la présente invention à d'autres blocs atténuateurs présentant des rapports d'atténuation différents.

La présente invention a été décrite en relation avec un élément de conversion courant/tension 28 particulier, mais l'homme du métier adaptera sans difficultés la présente invention à tout élément de conversion courant/tension équivalent.

Dans la description précédente, la première entrée IN1 du bloc 26 reçoit la somme des courants positifs I1⁺ produits par les éléments transconducteurs G1i et des courants négatifs I2⁻ produits par les éléments transconducteurs G2i. De même, la seconde entrée IN2 du bloc 26 reçoit la somme des courants négatifs I1⁻ produits par les éléments transconducteurs G1i et des courants positifs I2⁺ produits par les éléments transconducteurs G2i. Cependant, l'homme du métier adaptera sans difficultés la présente invention au cas où la première entrée IN1 du bloc 26 reçoit la somme des courants négatifs I1⁻ produits par les éléments transconducteurs G1i et des courants positifs I2⁺ produits par les éléments transconducteurs G2i, et où la seconde entrée IN2 du bloc 26 reçoit la somme des courants positifs I1⁺ produits par les éléments transconducteurs G1i et des courants négatifs I2⁻ produits par les éléments transconducteurs G2i.

## Revendications

1. Amplificateur à entrée et sortie différentielles à gain variable comprenant :
un bloc atténuateur (AT1, AT2). référencé au potentiel de mode commun (VCM) de la sortie de l'amplificateur, recevant une tension d'entrée (Vlin-V2in) et propre à fournir sur plusieurs sorties (O1i, O2i) des tensions dont chacune est égale à la tension d'entrée (V1in-V2in) atténuée selon un rapport prédéterminé,
des éléments transconducteurs différentiels (G1i, G2i) commandables en courant, chaque élément transconducteur différentiel ayant une première entrée reliée à une sortie (O1i, O2i) du bloc atténuateur, chaque élément transconducteur différentiel produisant des premier (I1⁺) et second (I2⁺) courants positifs et des premier (I1⁻) et second (I2⁻) courants négatifs,
un ensemble de sources de courant (10) propre à commander la transconductance de chaque élément transconducteur différentiel (G1i, G2i) en fonction d'un signal de commande analogique (Vcom), et
un bloc de sortie (26) convertissant des premier et second courants d'entrée en une tension de sortie différentielle (V1out-V2out) et fournissant à une seconde entrée de chaque élément transconducteur différentiel une tension de contre-réaction dépendant de la tension de sortie, le premier courant d'entrée étant égal à la somme des premiers courants positifs (I1⁺) et des seconds courants négatifs (I2⁻) et le second courant d'entrée étant égal à la somme des seconds courants positifs (I2⁺) et des premiers courants négatifs (I1⁻) .

2. Amplificateur selon la revendication 1, dans lequel :
le bloc atténuateur (AT1, AT2) comprend deux réseaux atténuateurs de type R/2R recevant respectivement des premier (V1in) et second (V2in) potentiels d'entrée, chaque sortie du bloc atténuateur comprenant un noeud de sortie (O1i , O2i), de chaque réseau atténuateur, le noeud de sortie produisant un potentiel atténué égal au potentiel d'entrée reçu par ledit réseau, atténué selon le rapport prédéterminé propre à ladite sortie,
chaque élément transconducteur différentiel (G1i, G2i) comprend deux couples de transistors bipolaires, les émetteurs des transistors d'un premier couple étant reliés à une première borne de commande en courant de l'élément transconducteur différentiel, et les émetteurs des transistors du second couple étant reliés à une seconde borne de commande en courant de l'élément transconducteur différentiel, la première entrée de l'élément transconducteur différentiel étant constituée par les bases de deux premiers transistors des deux couples de transistors, la seconde entrée de l'élément transconducteur différentiel étant constituée par les bases des deux seconds transistors des deux couples de transistors, les deux bases constituant la première entrée de l'élément transconducteur différentiel étant respectivement reliées aux deux noeuds de sortie (O1i, O2i) de la sortie du bloc atténuateur reliée à l'élément transconducteur différentiel, les deux bases constituant la seconde entrée de l'élément transconducteur différentiel étant soumises à la tension de contre-réaction, les collecteurs des premiers transistors produisant les premier (I1⁺) et second (I2⁺) courants positifs, et les collecteurs des seconds transistors produisant les premier (I1⁻) et second (I2⁻) courants négatifs, et
l'ensemble de sources de courant (10) comporte des couples de bornes de commande reliés aux première et seconde bornes de commande en courant de chaque élément transconducteur différentiel (G1i, G2i).

3. Amplificateur selon la revendication 1 ou 2, dans lequel le bloc de sortie (26) comporte :
un élément de conversion courant/tensions (28) ayant des première (IN1') et seconde (IN2') bornes d'entrée respectivement prévues pour recevoir les premier et second courants d'entrée, produisant le potentiel de mode commun (VCM) sur une borne de sortie de mode commun, et produisant respectivement des premier (V1out) et second (V2out) potentiels de sortie sur des première et seconde bornes de sortie (OUT1, OUT2),
des premier (R1, R2) et second (R3, R4) ponts diviseurs résistifs respectivement disposés entre les première et seconde bornes de sortie (OUT1, OUT2) de l'élément de conversion courant/tension (28) et le potentiel de mode commun (VCM), le point milieu des premier (R1, R2) et second (R3, R4) ponts diviseurs résistifs produisant la tension de contre-réaction, et
des première et seconde sources de courant (CS5, CS6) respectivement disposées entre un potentiel d'alimentation (VDD) et les première (IN1) et seconde (IN2) bornes d'entrée du bloc de sortie (26).

4. Amplificateur selon la revendication 3, dans lequel l'élément de conversion courant/tension (28) comprend :
des premier (T1) et deuxième (T2) transistors MOS identiques de type P, dont les sources sont reliées au potentiel d'alimentation (VDD), dont les grilles sont reliées l'une à l'autre, dont les drains respectifs sont reliés aux première (IN1') et seconde (IN2') bornes d'entrée de l'élément de conversion courant/tension (28),
des troisième (T3) et quatrième (T4) transistors MOS identiques, de type P, dont les sources sont reliées au potentiel d'alimentation (VDD), dont les grilles respectives sont reliées aux drains respectifs des premier (T1) et deuxième (T2) transistors MOS, dont les drains respectifs sont reliés aux première (OUT1) et seconde (OUT2) bornes de sortie de l'élément de conversion courant/tension (28),
des troisième (CS7) et quatrième (CS8) sources de courant disposées entre les drains respectifs des troisième (T3) et quatrième (T4) transistors et un premier potentiel de référence (GND)
deux résistances identiques (R) reliées chacune entre les drains respectifs des troisième (T3) et quatrième (T4) transistors et la borne de sortie de mode commun, et
un amplificateur différentiel (30) dont une première entrée est reliée à la borne de sortie de mode commun, dont une seconde entrée est reliée à un second potentiel de référence (Vref), et dont la sortie est reliée aux grilles des premier et second transistors (T1, T2).

## Claims

1. A variable-gain amplifier with differential input and output, including:
an attenuator block (AT1, AT2) referenced to the common mode voltage (VCM) of the amplifier output, receiving an input voltage (V1in-V2in) and adapted to providing, on several outputs (O1i, O2i), voltages, each of which is equal to the input voltage (V1in-V2in) attenuated according to a predetermined ratio,
differential transconductor elements (G1i, G2i) controllable by a current, each differential transconductor element having a first input connected to an output (O1i, O2i) of the attenuator block, each differential transconductor element generating first (I1⁺) and second (I2⁺) positive currents and first (I1⁻) and second (I2⁻) negative currents,
a current source assembly (10) adapted to controlling the transconductance of each differential transconductor element (G1i, G2i) according to an analog control signal (Vcom), and
an output block (26) converting first and second input currents into a differential output voltage (V1out-V2out) and providing a second input of each differential transconductor element with a feedback voltage depending on the output voltage, the first input current being equal to the sum of the first positive currents (I1⁺) and of the second negative currents (I2⁻) and the second input current being equal to the sum of the second positive currents (I2⁺) and of the first negative currents (I1⁻).

2. The amplifier of claim 1, wherein:
the attenuator block (AT1, AT2) includes two attenuator networks of R/2R type, respectively receiving first (V1in) and second (V2in) input voltages, each output of the attenuator block including an output node (O1i, O2i) of each attenuator network, the output node generating an attenuated voltage equal to the input voltage received by said network, attenuated according to the predetermined ratio specific to said output,
each differential transconductor element (G1i, G2i) includes two pairs of bipolar transistors, the emitters of the transistors of a first pair being connected to a first current control terminal of the differential transconductor element, and the emitters of the transistors of the second pair being connected to a second current control terminal of the differential transconductor element, the first input of the differential transconductor element being formed by the bases of the first two transistors of the two transistor pairs, the second input of the differential transconductor element being formed by the bases of the two second transistors of the two transistor pairs, the two bases forming the first input of the differential transconductor element being respectively connected to the output nodes (O1i, O2i) of the output of the attenuator block connected to the differential transconductor element, the two bases forming the second input of the differential transconductor element being submitted to the feedback voltage, the collectors of the first transistors generating the first (I1⁺) and second (I2⁺) positive currents, and the collectors of the second transistors generating the first (I1⁻) and second (I2⁻) negative currents, and
the current source assembly (10) includes pairs of control terminals connected to the first and second current control terminals of each differential transconductor element (G1i, G2i).

3. The amplifier of claim 1 or 2, wherein the output block (26) includes:
a current-to-voltage conversion element (28) having first (IN1') and second (IN2') input terminals respectively provided for receiving the first and second input currents, generating the common mode voltage (VCM) on a common mode output terminal, and respectively generating first (V1out) and second (V2out) output voltages on first and second output terminals (OUT1, OUT2),
first (R1, R2) and second (R3, R4) resistive dividing bridges respectively arranged between the first and second output terminals (OUT1, OUT2) of the current-to-voltage conversion element (28) and the common mode voltage (VCM), the midpoint of the first (R1, R2) and second (R3, R4) resistive dividing bridges generating the feedback voltage, and
first and second current sources (CS5, CS6) respectively arranged between a supply voltage (VDD) and the first (IN1) and second (IN2) input terminals of the output block (26).

4. The amplifier of claim 3, wherein the current-to-voltage conversion element (28) includes:
first (T1) and second (T2) identical P-type MOS transistors, having their sources connected to the supply voltage (VDD), having their gates connected to each other, having their respective drains connected to the first (IN1') and second (IN2') input terminals of the current-to-voltage conversion element (28),
third (T3) and fourth (T4) identical P-type MOS transistors, having their sources connected to the supply voltage (VDD), having their respective gates connected to the respective drains of the first (T1) and second (T2) MOS transistors, having their respective drains connected to the first (OUT1) and second (OUT2) output terminals of the current-to-voltage conversion element (28),
third (CS7) and fourth (CS8) current sources arranged between the respective drains of the third (T3) and fourth (T4) transistors and a first reference voltage (GND),
two identical resistors (R) each connected between the respective drains of the third (T3) and fourth (T4) transistors and the common mode output terminal, and
a differential amplifier (30) having a first input connected to the common mode output terminal, having a second input connected to a second reference voltage (Vref), and having its output connected to the gates of the first and second transistors (T1, T2).

## Patentansprüche

1. Ein Verstärker mit veränderbarer Verstärkung mit einem Differenzeingang und -ausgang, wobei Folgendes vorgesehen ist:
ein Dämpfungsblock (AT1, AT2), der in Bezug steht mit einer Common-Mode-Spannung (VCM) des Verstärkerausgangs, der eine Eingangsspannung (V1 in-V2in) empfängt, und geeignet ist, um an mehreren Ausgängen (O1i, O2i) Spannungen zu liefern, deren jede gleich der Eingangsspannung (V1 in-V2in) gedämpft, gemäß einem vorbestimmten Verhältnis, ist,
Differenztranskonduktorelemente (G1i, G2i), steuerbar durch einen Strom, wobei jedes Differenztranskonduktorelement einen ersten Eingang, verbunden mit einem Ausgang (O1i, O2i) des Dämpfungsblocks aufweist, wobei jedes Differenztranskonduktorelement erste (I1⁺) und zweite (I2⁺) positive Ströme und erste (I1⁻) und zweite (I2⁻) negative Ströme erzeugt,
eine Stromquellenanordnung (10), geeignet zur Steuerung der Transkonduktanz jedes Differenztranskonduktorelements (G1i, G2i), entsprechend einem analogen Steuersignal (Vcom), und
einen Ausgangsblock (26) der erste und zweite Eingangsströme in eine Differenzausgangsspannung (V1out-V2out) umwandelt, und eine zweite Eingangsgröße jedes Differenztranskonduktorelements liefert, und zwar mit einer Rückkupplungsspannung, abhängig von der Ausgangsspannung, wobei der erste Eingangsstrom gleich der Summe der ersten positiven Ströme (I1⁺) und der zweiten negativen Ströme (I2⁻) ist, und der zweite Eingangsstrom gleich der Summe der zweiten positiven Ströme (I2⁺) und der ersten negativen Ströme (I1⁻) ist.

2. Verstärker nach Anspruch 1, wobei:
der Dämpfungsblock (AT1, AT2) zwei Dämpfungsnetzwerke des R/2R-Typs aufweist, die jeweils erste (V1in) und zweite (V2in) Eingangsspannungen empfangen, wobei jede Ausgangsgröße des Dämpfungsblocks einen Ausgangsknoten (O1i, O2i) jedes Dämpfungsnetzwerks aufweist,
wobei der Ausgangsknoten eine gedämpfte Spannung erzeugt, gleich der, durch das Netzwerk empfangenen, Eingangsspannung, und zwar gedämpft gemäß dem vorbestimmten Verhältnis, spezifisch bzw. entsprechend der erwähnten Ausgangsgröße,
wobei jedes Differenztranskonduktorelement (G1i, G2i) zwei Paare von bipolaren Transistoren aufweist, wobei die Emitter der Transistoren eines ersten Paares verbunden sind mit einem ersten Stromsteueranschluss des Differenztranskonduktorelements, und wobei die Emitter der Transistoren des zweiten Paares verbunden sind mit einem zweiten Stromsteueranschluss des Differenztranskonduktorelements, und wobei ferner der erste Eingang des Differenztranskonduktorelements gebildet wird durch die Basen der ersten zwei Transistoren der zwei Transistorpaare, und wobei der zweite Eingang des Differenztranskonduktorelements gebildet wird durch die Basen der zwei zweiten Transistoren der zwei Transistorpaare, wobei ferner die zwei Basen, die den ersten Eingang des Differenztranskonduktorelements bilden, jeweils verbunden sind mit den Ausgangsknoten (O1i, O2i) des Ausgangs des Dämpfungsblocks, verbunden mit dem Differenztranskonduktorelement, und wobei die zwei Basen, die den zweiten Eingang des Differenztranskonduktorelements bilden, der Rückkopplungsspannung ausgesetzt sind, wobei die Kollektoren der ersten Transistoren die ersten (I1⁺) und die zweiten (I2⁺) positiven Ströme erzeugen, und die Kollektoren der zweiten Transistoren die ersten (I1⁻) und die zweiten (I2⁻) negativen Ströme erzeugen, und
wobei die Stromquellenanordnung (10) Paare von Steueranschlüssen aufweist, verbunden mit den ersten und zweiten Stromsteueranschlüssen von jedem Differenztranskonduktorelement (G1i, G2i).

3. Verstärker nach Anspruch 1 oder 2, wobei der Ausgangsblock (26) Folgendes aufweist:
ein Strom-zu-Spannungs-Umwandlungselement (28) mit ersten (IN1') bzw. zweiten (IN2') Eingangsanschlüssen, vorgesehen zum Empfang der ersten bzw. zweiten Eingangsströme, zur Erzeugung der Common-Mode-Spannung (VCM) an einem Common-Mode-Ausgangsanschluss, und zur entsprechenden Erzeugung erster (V1out) und zweiter (V2out) Ausgangsspannungen auf ersten und zweiten Ausgangsanschlüssen (OUT1, OUT2),
erste (R1, R2) und zweite (R3, R4) Widerstandsteilerbrücken, die jeweils angeordnet sind zwischen den ersten und zweiten Ausgangsanschlüssen (OUT1, OUT2) des Strom-zu-Spannungs-Umwandlungselements (28) und der Common-Mode-Spannung (VCM), wobei der Mittelpunkt der ersten (R1, R2) und zweiten (R3, R4) Widerstandsteilerbrücken die Rückkopplungsspannung erzeugt, und
erste und zweite Stromquellen (CS5, CS6), die jeweils angeordnet sind zwischen einer Versorgungsspannung (VDD) und den ersten (IN1) und zweiten (IN2) Eingangsanschlüssen des Ausgangsblocks (26).

4. Verstärker nach Anspruch 3, wobei das Strom-zu-Spannungs-Umwandlungselement (28) Folgendes aufweist:
erste (T1) und zweite (T2) identische P-Typ-MOS-Transistoren, deren Quellen mit der Versorgungsspannung (VDD) verbunden sind, und wobei deren Gates miteinander verbunden sind, und deren entsprechende Drains mit den ersten (IN1') und den zweiten (IN2') Eingangsanschlüssen des Strom-zu-Spannungs-Umwandlungselements (28) verbunden sind,
dritte (T3) und vierte (T4) identische P-Typ-MOS-Transistoren, deren Sources mit der Versorgungsspannung (VDD) verbunden sind, deren entsprechende Gates mit den entsprechenden Drains der ersten (T1) und zweiten (T2) MOS-Transistoren verbunden sind, die ihre entsprechenden Drains mit den ersten (OUT1) und zweiten (OUT2) Ausgangsanschlüssen des Strom-zu-Spannungs-Umwandlungselements (28) verbunden haben,
dritte (CS7) und vierte (CS8) Stromquellen, angeordnet zwischen entsprechenden Drains der dritten (T3) und vierten (T4) Transistoren und einer ersten Bezugsspannung (GND),
zwei identische Widerstände (R), jeweils verbunden zwischen den entsprechenden Drains der dritten (T3) und vierten (T4) Transistoren und dem Common-Mode-Ausgangsanschluss, und
einen Differenzverstärker (30) mit einem ersten Eingang, verbunden mit dem Common-Mode-Ausgangsanschluss, mit einem zweiten Eingang, verbunden mit einer zweiten Bezugsspannung (Vref) und mit seinem Ausgang, verbunden mit den Gates der ersten und zweiten Transistoren (T1, T2).
